# EUROPEAN PATENT APPLICATION

(11) **EP 0 576 025 A2**
(43) Date of publication of application: **29.12.1993**
(21) Application number: 93110190.1
(22) Date of filing: 25.06.1993
(51) Int. Cl.: H01L 27/06, H01L 21/82

(54) **Semiconductor device and production method thereof**

(30) Priority: 26.06.1992 JP 169201/92
(71) Applicant: Sumitomo Electric Industries, Ltd., Osaka 541 (JP)
(72) Inventor: Kuwata, Nobuhiro, c/o Yokohama Works of Sumitomo, Yokohama-shi, Kanagawa (JP)
(74) Representative: Lehn, Werner, Dipl.-Ing.

(57) **Abstract**

At least two types of field effect transistors are integrated on a single substrate, which are selected from a type of field effect transistor having a channel of a pulse-doped layer and a threshold voltage defined by the thickness and the carrier concentration of the pulse-doped layer, a type of field effect transistor having a channel of a crystal layer ion-implanted and a threshold voltage defined by an amount of ion implantation into the crystal layer, and a type of field effect transistor having a channel of an ion-implanted region in the pulse-doped layer and a threshold voltage defined by the carrier concentration of the pulse-doped layer, the thickness of the pulse-doped layer, and an amount of ion implantation into the pulse-doped layer.

## Description

### BACKGROUND OF THE INVENTION

### Field of the Invention

The present invention specifically relates to a microwave monolithic integrated circuit (MMIC) capable of operating at high speed and excellent with low noise characteristics, and to a method for producing it.

### Related Background Art

There has been known a high electron mobility transistor (HEMT) using the selective doping heterojunction of Si-AlGaAs/GaAs as a device excellent with low noise characteristics and capable of operating at high speed. Also, a pulse-doped MESFET using a Si pulse-doped GaAs layer was proposed as a device not using the heterojunction but using the homojunction of Si-GaAs/GaAs, which was excellent with low noise characteristics and capable of operating at high speed. This is described in detail in Reference "Technical Document ED89-152 pp7-12, Institute of Electronics, Information and Communication Engineers of Japan."

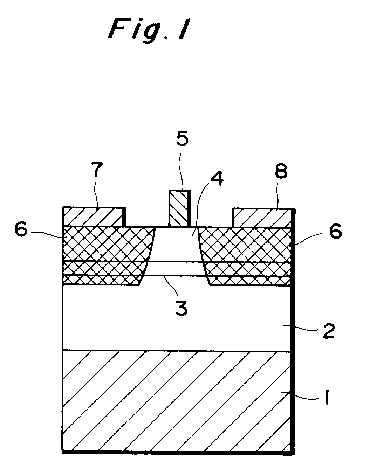

Fig. 1 shows the structure of pulse-doped MESFET as described above. This structure may be attained by forming a plurality of semiconductor crystal layers on a semi-insulating GaAs substrate 1 by an epitaxial growth technique such as the molecular-beam epitaxy (MBE) technique and the organo-metallic vapor phase epitaxy (OMVPE) technique. For example, as shown in Fig. 1, there are built up in the named order on the GaAs substrate 1, an undoped GaAs buffer layer 2 of p-type carrier conduction in carrier concentration of not more than 5x10¹⁵ cm⁻³, a Si pulse-doped GaAs layer 3 in carrier concentration of 4x10¹⁸ cm⁻³, and an undoped GaAs cap layer 4 of n-type carrier conduction in carrier concentration of not more than 1x10¹⁵ cm⁻³. Formed on such a pulse-doping structure are a gate electrode 5, an n⁺ ion implanted layer 6 formed in a self-aligning manner relative to the gate electrode, a source electrode 7, and a drain electrode 8. This electrode structure is called as the planar structure, because the gate electrode is formed planar or flat on the crystal layers.

Further, a conventional FET is described for example in reference "U.S. PATENT 4,163,984 by Pucel et al.".

### SUMMARY OF THE INVENTION

In the above-described pulse-doped MESFET a threshold voltage Vₜₕ is uniquely determined by the thickness and the carrier concentration of Si pulse-doped layer 3, and the thickness of undoped GaAs cap layer 4. There was such inconvenience caused in production of microwave monolithic integrated circuit (MMIC) in which pulse-doped MESFETs were made integrated that all circuits must have been constructed with FETs having a single threshold voltage.

For example, a pulse-doped MESFET having good noise characteristics and a low threshold voltage Vₜₕ is suitable for an amplifier which initially receives a signal with high frequency over GHz level. In contrast, a MESFET having a high threshold voltage Vₜₕ, which allows a great amount of current flow, is preferable for an oscillator or a mixer for converting a signal with high frequency into one with low frequency of MHz level, or for an amplifier for amplifying a signal with lower frequency. The pulse-doped MESFET does not always have to be used in this case.

As described, a MESFET as a constituent element of circuit has an optimum threshold voltage Vₜₕ depending upon a function of each circuit. The conventional techniques only allowed the MMIC to be produced with pulse-doped MESFETs having a single threshold voltage Vₜₕ in production of integrated circuit on a substrate.

In order to have variations of threshold voltage Vₜₕ of FETs as described, such a method is employed that recess (groove) etching is carried out immediately before forming the gate electrode to remove a part of undoped GaAs cap layer so as to make the thickness of cap layer thinner. The recess etching, however, has problems regarding uniformity and reproducibility, which is thus not always most suitable as the method for producing an integrated circuit.

It is an object of the present invention to provide a microwave monolithic integrated circuit capable of operating at high speed and excellent with low noise characteristics, and to provide a production method thereof.

The present invention is characterized in that a semiconductor device is provided with a plurality of field effect transistors formed by building up crystal layers on a substrate, in which at least two types of field effect transistors selected from the following (a)-(c) types are integrated on the single substrate: (a) a type of field effect transistor having a channel of a pulse-doped layer and having a threshold voltage defined by the carrier concentration and the thickness of the pulse-doped layer; (b) a type of field effect transistor having a channel of a crystal layer built up on the substrate and then ion-implanted and having a threshold voltage defined by an amount of ion implantation in the crystal layer; and (c) a type of field effect transistor having a channel of a pulse-doped layer and the crystal layers ion-implanted and having a threshold voltage defined by the carrier concentration and the thickness of the pulse-doped layer, and by an amount of ion implantation in the crystal layers including the pulse-doped layer.

In detail, the present invention provides a semiconductor device comprising: a semiconductor (semi-insulating) substrate; a buffer layer formed by epitaxial growth on said semiconductor substrate; and at least two elements selected from the group consisting of a first semiconductor element, a second semiconductor element and a third semiconductor element, and
said first semiconductor element comprising: a first ion-implanted region formed by ion implantation of impurity in said buffer layer in a first element forming region; and a first Schottky electrode and a first ohmic electrode provided in the first element forming region,
said second semiconductor element comprising: a pulse-doped layer formed by epitaxial growth in high concentration of impurity on said buffer layer in a second element forming region; a cap layer formed by epitaxial growth on said pulse-doped layer; and a second Schottky electrode and a second ohmic electrode provided in the second element forming region, and
said third semiconductor element comprising: a pulse-doped layer formed by epitaxial growth in high concentration of impurity on said buffer layer in a third element forming region; a cap layer formed by epitaxial growth on said pulse-doped layer; a second ion-implanted region in which an impurity is ion-implanted in a third element forming region in depth ranging from the upper surface of said cap layer into said pulse-doped layer; and a third Schottky electrode and a third ohmic electrode provided in the third element forming region.

And, this invention provides a method for producing a semiconductor device, comprising:
a first step of epitaxial growth of a buffer layer on a semiconductor (semi-insulating) substrate; a second step of epitaxial growth of a pulse-doped layer in high concentration of impurity on said buffer layer; a third step of epitaxial growth of a cap layer on said pulse-doped layer; a fourth step of etching of a desired region in depth ranging from the upper surface of said cap layer into said buffer layer to form a first element forming region; a fifth step of ion implantation of impurity into said buffer layer in the first element forming region to form a first ion-implanted region; and a sixth step of providing a first Schottky electrode and a first ohmic electrode in the first element region to form a first semiconductor element and providing a second Schottky electrode and a second ohmic electrode on said cap layer in a second element forming region to form a second semiconductor element.

Further, this invention provides a method for producing a semiconductor device, comprising:
a first step of epitaxial growth of a buffer layer on a semiconductor (semi-insulating) substrate; a second step of epitaxial growth of a pulse-doped layer in high concentration of impurity on said buffer layer; a third step of epitaxial growth of a cap layer on said pulse-doped layer; a fourth step of ion implantation of impurity in a first element forming region in depth ranging from the upper surface of said cap layer into said pulse-doped layer to form an ion-implanted region; and a fifth step of providing a first Schottky electrode and a first ohmic electrode in the first element forming region and providing a second Schottky electrode and a second ohmic electrode in a second element forming region.

According to the present invention, plural MESFETs different in threshold voltage are present in an integrated circuit formed on a single substrate, so that the single integrated circuit may have various functions.

Further, according to the production method of the present invention, various types of MESFETs different in threshold voltage Vₜₕ may be freely produced on a single substrate in a combination of the carrier concentration and the thickness of semiconductor layer formed by crystal growth with the ion implantation conditions, so that an integrated circuit may be readily provided with desired functions.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

### BRIEF DESCRIPTION OF THE DRAWINGS

Fig. 1 is a cross sectional view to show the structure of a conventional semiconductor device with pulse-doped structure;
Fig. 2 is a cross sectional view to show the structure of a semiconductor device as an embodiment of the present invention;
Fig. 3 to Fig. 8 are drawings to show a method for producing the semiconductor device in the embodiment of the present invention.

### DESCRIPTION OF THE PREFERRED EMBODIMENTS

The embodiments of the present invention will be described in detail with reference to the accompanying drawings.

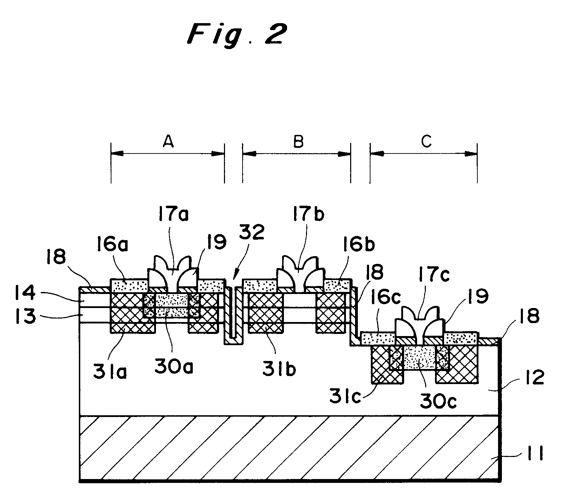

Fig. 2 is a structural cross sectional view of a semiconductor device according to the present invention. A substantially no impurity GaAs buffer layer 12 is formed on a semi-insulating (semiconductor) GaAs substrate 11, in which a plurality of MESFETs different in structure are formed.

Characters A-C respectively denote MESFETs with respective structures different from one another.

Character A represents a region in which a FET is formed with a channel of a pulse-doped layer 13 and a ion-implanted region 30a. High concentration carriers are confined in the a pulse-doped layer 13. A part of a cap layer 14 and the pulse-doped layer 13 is ion-implanted and the ion-implanted region 30a is formed. The FET has a threshold voltage which is defined by the carrier concentration of the pulse-doped layer 13, the thickness of the pulse-doped layer 13, and an amount of ion implantation in the ion-implanted region 30a.

Character B represents a region in which a FET is formed with a channel of a pulse-doped layer 13 which is formed on the substantially no impurity GaAs buffer layer 12 and in which high concentration carriers are confined. This FET has a threshold voltage which is defined by the carrier concentration of the pulse-doped layer 13 and the thickness of the pulse-doped layer 13.

Character C represents a region in which a FET is formed with a channel of a ion-implanted region 30c. A part of the substantially no impurity GaAs buffer layer 12 is ion-implanted and the ion-implanted region 30c is formed. The FET has a threshold voltage defined by an amount of ion implantation in the ion-implanted region 30c.

The MESFETs different in threshold voltage Vₜₕ are thus integrated on the single substrate, whereby a single integrated circuit may have various functions.

There will be described in more detail the structure of the semiconductor device according to the present invention as described in Fig. 2. The semiconductor device is constructed by three types of FETs as formed in the respective regions of characters A, B, and C.

The FET in the region of character A is formed as follows. The buffer layer 12 is formed of substantially no impurity GaAs by epitaxial growth on the substrate 11 made of semi-insulating GaAs. Further, the pulse-doped layer 13 is formed of GaAs containing Si as impurity in high concentration by epitaxial growth on the buffer layer, and the cap layer 14 is formed of substantially no impurity GaAs by epitaxial growth on the pulse-doped layer.

Si is ion-implanted in the central portion of Region A in the cap layer 14 in depth ranging from the upper surface of the cap layer 14 into the pulse-doped layer 13 to form an ion-implanted region 30a. Further, Si is ion-implanted in two regions adjacent to the ion-implanted region 30a on either side thereof in depth ranging from the upper surface of the cap layer 14 into the buffer layer 12 to form two contact regions 31a.

A gate electrode 17a is formed in Schottky contact on the ion-implanted region 30a. Also, a source electrode and a drain electrode 16a are formed in ohmic contact on the two contact regions 31a. The gate electrode 17a is electrically separated by a SiNx film 18 and a SiO₂ film 19 from the source-drain electrodes 16a and the contact regions 31a.

The FET in the region of character B is formed as follows. As described above, the buffer layer 12, the pulse-doped layer 13, and the cap layer 14 are formed by epitaxial growth on the substrate 11.

Si is ion-implanted in two regions on either side of the central portion of Region B in the cap layer 14 in depth ranging from the upper surface of the cap layer 14 into the buffer layer 12 to form two contact regions 31b.

A gate electrode 17b is formed in the central portion on the cap layer. Also, a source electrode and a drain electrode 16b are formed on the two contact regions 31b, respectively. The gate electrode 17b is electrically separated by the SiNx film 18 and the SiO₂ film 19 from the source-drain electrodes 16b and the contact regions 31b.

The FET in the region of character C is formed as follows. As described above, the buffer layer 12 is formed by epitaxial growth on the substrate 11. Si is ion-implanted in the central portion of Region C in the buffer layer 12 to form an ion-implanted region 30c. Further, Si is ion-implanted in two regions adjacent to the ion-implanted region 30c on either side thereof to form two contact regions 31c.

A gate electrode 17c is formed in Schottky contact on the ion-implanted region 30c. Also, a source electrode and a drain electrode 16c are formed in ohmic contact on the two contact regions 31c, respectively. The gate electrode 17c is electrically separated by the SiNx film 18 and the SiO₂ film 19 from the source-drain electrodes 16c and the contact regions 31c. The FET in Region A is separated by a groove 32 formed by etching from the FET in Region B. The groove 32 is also covered by the SiNx film 18.

The two FETs in Region A and in Region B are formed at a height elevated approximately by the total thickness of the pulse-doped layer 13 and the cap layer 14 with respect to the formation region of the FET in Region C, as shown in Fig. 2. The FETs in Regions A, B, C are formed with common substrate 11 and common buffer layer 12, providing the entire semiconductor device with a stepped structure.

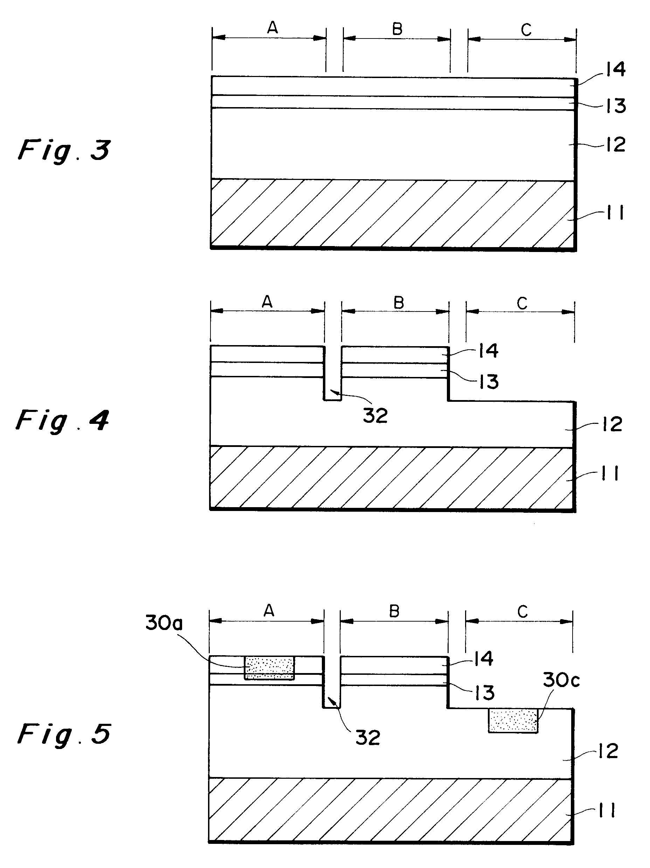

Next explained with Fig. 3 to Fig. 8 is a method for producing the semiconductor device according to the present invention. Semiconductor crystal layers are first built up on the semi-insulating (semiconductor) substrate 11 by using an epitaxial growth technique such as the molecular-beam epitaxy (MBE) technique and the organo-metallic vapor phase epitaxy (OMVPE) technique. In the present embodiment the substantially no impurity GaAs buffer layer 12 is of 10,000 angstroms with carriers of p-type conduction and in carrier concentration of not more than 5x10¹⁵ cm⁻³, the Si pulse-doped GaAs layer 13 is of 80 angstroms in carrier concentration of 4x10¹⁸ cm⁻³, and the substantially no impurity GaAs cap layer 14 is of 400 angstroms with carriers of n-type conduction and in carrier concentration of 1x10¹⁵ cm⁻³, which are consecutively formed (Fig. 3).

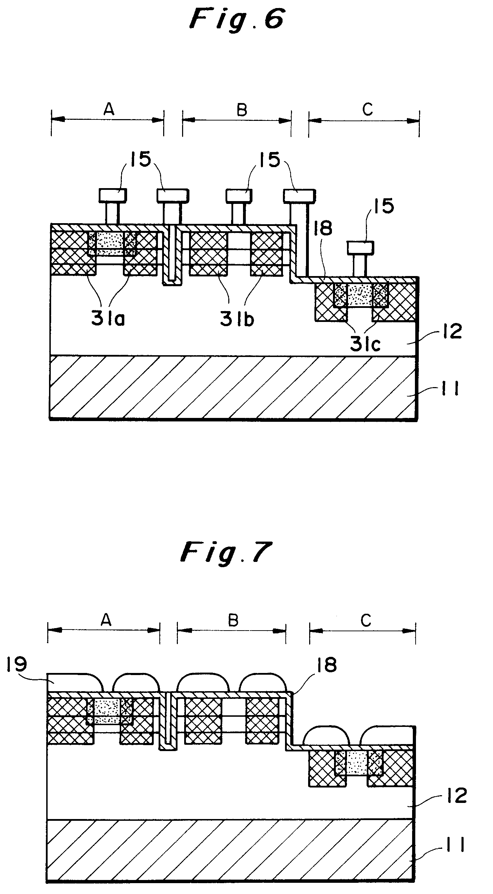

The mesa-etching with ammoniacal etching solution is then effected in the portion except for regions where the MESFETs represented by characters A-C are to be formed, in depth of about 2800 angstroms into the substantially no impurity GaAs buffer layer 12 (as shown in Fig. 4). By this etching, the groove 32 is formed to separate Region A from Region B. If a MESFET is desired not to have the pulse-doping structure, the crystal layers are removed in a formation region corresponding to the MESFET up to a depth in which the substantially no impurity GaAs buffer layer 12 is exposed, as shown in Region C. Si is then ion-implanted in MESFET forming regions, for example in the central portions of Regions A, C as shown in Fig. 5, under the conditions of acceleration voltage of 30 keV and dose of 5x10¹² cm⁻². Accordingly, the ion-implanted regions 30a, 30c are formed.

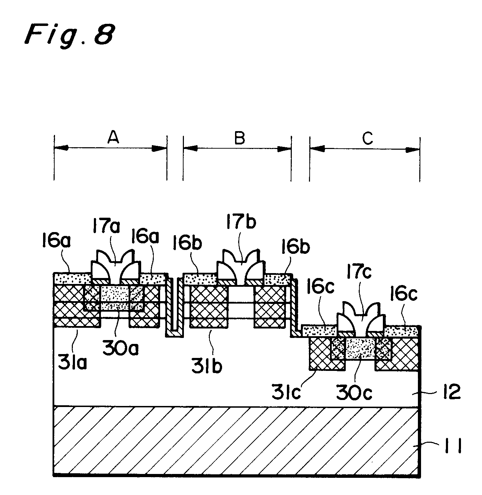

The SiNx film 18 is then formed in 800 angstroms over the entire surface, and T-shaped dummy gates 15 are formed on the three central portions of Regions A, B, C and on two borders between the regions. Using the dummy gates 15 as mask, Si is ion-implanted with acceleration voltage of 90 keV and in dose of 4x10¹³ cm⁻² (as shown in Fig. 6). The contact regions 31a-31c are thus formed. After that, the SiO₂ film 19 is deposited by sputtering, and the dummy gates 15 are removed (as shown in Fig. 7). Then, annealing is effected in atmosphere at 850 °C for three seconds to activate the implanted Si. By conventional procedure the source and drain electrodes 16a-16c are then formed on the contact regions 31a-31c, and the gate electrodes 17a-17c are on the central portions of Regions A, B, C (specifically on the ion-implanted regions 30a, 30c in Regions A and C), as shown in Fig. 8.

The three types of MESFETs as denoted by characters A-C (the regions A-C) are thus completed by the production method as described. Threshold voltages Vₜₕ of these MESFETs were measured, which were Vₜₕ=-1.2 V for the FET in Region A, Vₜₕ=-0.7 V for the FET in Region B, and Vₜₕ=-0.4 V for the FET in Region C, assuring that the FETs have the threshold voltages Vₜₕ different from one another.

In the embodiment the pulse-doped layer 13 is a n⁺-type semiconductor layer in carrier concentration of 1x10¹⁸ cm⁻³, but may be in carrier concentration of not less than 1x10¹⁷ cm⁻³,

In the embodiment the buffer layer 12 is of p⁻-type substantially no impurity GaAs. To obtain such buffer layer 12 by the OMVPE, more gas of Ga component of III-group element is supplied than gas of As component of V-group element. Moreover, the cap layer 14 is of n⁻-type substantially no impurity GaAs. To obtain such cap layer 14 by the OMVPE, more gas of As component of V-group element is supplied than gas of Ga component of III-group element.

In case of use of the MBE technique, a micro amount of Be may be doped to form the buffer layer 12 (of p⁻-type), and a micro amount of Si may be doped to form the cap layer 14 (of n⁻-type).

Although the doping is carried out in micro amount, the layers are called as the substantially no impurity layer in the specification as far as a layer is of p⁻-type in carrier concentration of not more than 5x10¹⁶ cm⁻³ or of n⁻-type in carrier concentration of not more than 5x10¹⁵ cm⁻³. In general, the substantially no impurity layer may be called "an undoped layer".

In the embodiment there are the three types of FETs formed in the three Regions A, B, C, but a semiconductor device of the present invention may be formed with only two types of FETs out of the three types. Also, the ion implantation is simultaneously effected in the embodiment upon formation of the ion-implanted region 30a in Region A and the ion-implanted region 30c in Region C, but the ion implantation may be separately carried out in the respective regions.

Further, semiconductor elements formed on the semiconductor device are not limited to the FET, but may be diodes. Also, Regions A and B are separated from each other by the groove formed by etching in the embodiment, but may be separated by an insulating region formed by ion implantation.

Although the substrate and the respective layers are made mainly of GaAs in the embodiment. However, the main component is not limited to GaAs, but may be one selected from various semiconductors, for example AlGaAs and InP. Also, as for Si used in ion implantation, the implanted material is not limited to that, but may be one selected for example from S, Se, Ge, Sn, Be, Zn, Mn, and C.

As described above, various types of MESFETs different in Vₜₕ may be freely produced on a single substrate by a combination of the carrier concentration and the thickness of semiconductor layer formed by crystal growth with the conditions of ion implantation, so that MESFETs suitable for functions of circuit may be readily provided. Therefore, the present invention is effective to produce an integrated circuit, such as MMIC, in which circuits having various functions are combined.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A semiconductor device comprising:
a semiconductor substrate;
a buffer layer formed by epitaxial growth on said semiconductor substrate; and
at least two elements selected from the group consisting of a first semiconductor element, a second semiconductor element and a third semiconductor element, and
said first semiconductor element comprising:
a first ion-implanted region formed by ion implantation of impurity in said buffer layer in a first element forming region; and
a first Schottky electrode and a first ohmic electrode provided in the first element forming region,
said second semiconductor element comprising:
a pulse-doped layer formed by epitaxial growth in high concentration of impurity on said buffer layer in a second element forming region;
a cap layer formed by epitaxial growth on said pulse-doped layer; and
a second Schottky electrode and a second ohmic electrode provided in the second element forming region, and
said third semiconductor element comprising:
a pulse-doped layer formed by epitaxial growth in high concentration of impurity on said buffer layer in a third element forming region;
a cap layer formed by epitaxial growth on said pulse-doped layer;
a second ion-implanted region in which an impurity is ion-implanted in a third element forming region in depth ranging from the upper surface of said cap layer into said pulse-doped layer; and
a third Schottky electrode and a third ohmic electrode provided in the third element forming region.

2. A semiconductor device according to Claim 1, wherein said buffer layer is a p⁻-type semiconductor layer in carrier concentration of not more than 5x10¹⁶ cm⁻³, said pulse-doped layer is an n⁺-type semiconductor layer in carrier concentration of not less than 1x10¹⁷ cm⁻³, said cap layer is an n⁻-type semiconductor layer in carrier concentration of not more than 5x10¹⁵ cm⁻³, and said ion-implanted region is of n⁺-type.

3. A semiconductor device according to Claim 1, wherein said first semiconductor element further comprises another first ohmic electrode, and wherein first Schottky electrode is a gate electrode, said first ohmic electrodes are a source electrode and a drain electrode, and said first semiconductor element is a FET.

4. A semiconductor device according to Claim 1, wherein said second semiconductor element further comprises another second ohmic electrode, and wherein said second Schottky electrode is a gate electrode, said second ohmic electrodes are a source electrode and a drain electrode, and said second semiconductor element is a FET.

5. A semiconductor device according to Claim 1, wherein said third semiconductor element further comprises another third ohmic electrode, and wherein said third Schottky electrode is a gate electrode, said third ohmic electrodes are a source electrode and a drain electrode, and said third semiconductor element is a FET.

6. A semiconductor device according to Claim 1, wherein said first ohmic electrode is formed on desired contact regions ion-implanted.

7. A semiconductor device according to Claim 1, wherein said second ohmic electrode is formed on desired contact regions ion-implanted.

8. A semiconductor device according to Claim 1, wherein said third ohmic electrode is formed on desired contact regions ion-implanted.

9. A semiconductor device according to Claim 1, further comprising a element-separated region between said selected elements for electrical separating.

10. A method for producing a semiconductor device, comprising:
a first step of epitaxial growth of a buffer layer on a semiconductor substrate;
a second step of epitaxial growth of a pulse-doped layer in high concentration of impurity on said buffer layer;
a third step of epitaxial growth of a cap layer on said pulse-doped layer;
a fourth step of etching of a desired region in depth ranging from the upper surface of said cap layer into said buffer layer to form a first element forming region;
a fifth step of ion implantation of impurity into said buffer layer in the first element forming region to form a first ion-implanted region; and
a sixth step of providing a first Schottky electrode and a first ohmic electrode in the first element region to form a first semiconductor element and providing a second Schottky electrode and a second ohmic electrode on said cap layer in a second element forming region to form a second semiconductor element.

11. A method for producing a semiconductor device according to Claim 10, wherein said fifth step further comprises ion implantation of impurity in the second element forming region in depth ranging from the upper surface of said cap layer into said pulse-doped layer to form a second ion-implanted region.

12. A method for producing a semiconductor device according to Claim 10, wherein said fifth step further comprises ion implantation of impurity in a third element forming region in depth ranging from the upper surface of said cap layer into said pulse-doped layer to form a second ion-implanted region, and wherein said sixth step comprises providing a third Schottky electrode and a third ohmic electrode in the third element region.

13. A method for producing a semiconductor device according to Claim 10, wherein said sixth step includes a step of ion implantation in desired region to form contact regions, and a step of forming said first and second ohmic electrodes on said respective contact regions.

14. A method for producing a semiconductor device according to Claim 10, wherein said sixth step further includes a step of providing another first ohmic electrode in the first element forming region.

15. A method for producing a semiconductor device according to Claim 10, wherein said sixth step further includes a step of providing another second ohmic electrode in the second element forming region.

16. A method for producing a semiconductor device according to Claim 12, wherein said sixth step further includes a step of providing another third ohmic electrode in the third element forming region.

17. A method for producing a semiconductor device according to Claim 10, wherein said fourth step includes etching of a desired region between said first and said second element forming regions in depth ranging from the upper surface of said cap layer into said buffer layer to form a element-separated region for electrical separating.

18. A method for producing a semiconductor device, comprising:
a first step of epitaxial growth of a buffer layer on a semiconductor substrate;
a second step of epitaxial growth of a pulse-doped layer in high concentration of impurity on said buffer layer;
a third step of epitaxial growth of a cap layer on said pulse-doped layer;
a fourth step of ion implantation of impurity in a first element forming region in depth ranging from the upper surface of said cap layer into said pulse-doped layer to form an ion-implanted region; and
a fifth step of providing a first Schottky electrode and a first ohmic electrode in the first element forming region and providing a second Schottky electrode and a second ohmic electrode in a second element forming region.

19. A method for producing a semiconductor device according to Claim 18, wherein said sixth step includes a step of ion implantation in desired region to form contact regions, and a step of forming said first and second ohmic electrodes on said respective contact regions.

20. A method for producing a semiconductor device according to Claim 18, wherein said sixth step further includes a step of providing another first ohmic electrode in the first element forming region.

21. A method for producing a semiconductor device according to Claim 18, wherein said sixth step further includes a step of providing another second ohmic electrode in the second element forming region.

22. A method for producing a semiconductor device according to Claim 18, after said third step further comprising: a step of etching of a desired region between said first and said second element forming regions in depth ranging from the upper surface of said cap layer into said buffer layer to form a element-separated region for electrical separating.
